Europäisches Patentamt

European Patent Office

Office européen des brevets

(19)

(11) **EP 0 802 634 B1**

(12) **EUROPEAN PATENT SPECIFICATION**

(45) Date of publication and mention
of the grant of the patent:
**14.05.2003 Bulletin 2003/20**

(51) Int Cl.[7]: **H04L 25/03**

(21) Application number: **96307767.2**

(22) Date of filing: **28.10.1996**

(54) **Viterbi decoding method and circuit therefor**

Viterbi-Dekodierungsverfahren und Schaltung dafür

Méthode et circuit de décodage Viterbi

(84) Designated Contracting States:
**DE FR GB**

(30) Priority: **17.04.1996 KR 9611620**

(43) Date of publication of application:
**22.10.1997 Bulletin 1997/43**

(73) Proprietor: **Samsung Electronics Co., Ltd.**
**Suwon City, Kyungki-do (KR)**

(72) Inventors:
• **Soich, Iwamura**
**Suwon-city, Kyungki-do (KR)**
• **Jeon, Jin-kyu**
**Suwon-city, Kyungki-do (KR)**

(74) Representative: **Chugg, David John et al**
**Appleyard Lees,**
**15 Clare Road**
**Halifax, West Yorkshire HX1 2HY (GB)**

(56) References cited:
**EP-A- 0 594 551**

• **KNUDSON K J ET AL: "DYNAMIC THRESHOLD
IMPLEMENTATION OF THE
MAXIMUM-LIKELIHOOD DETECTOR FOR THE
EPR4 CHANNEL" PROCEEDINGS OF THE
GLOBAL TELECOMMUNICATIONS
CONFERENCE. (GLOBECOM),US,NEW YORK,
IEEE, vol. -, 2 December 1991 (1991-12-02),
pages 2135-2139, XP000313770 ISBN:
0-87942-697-7**
• **THAPAR H K ET AL: "A BLOCK PROCESSING
METHOD FOR DESIGNING HIGH-SPEED VIERBI
DETECTORS" INTERNATIONAL CONFERENCE
ON COMMUNICATIONS,US,NEW YORK, IEEE,
vol. -, 11 June 1989 (1989-06-11), pages
1096-1100, XP000075285**

## Description

The present invention relates to a Viterbi decoding method and a circuit therefor, and more particularly, to a Viterbi decoding method which is applied for high-speed and high-density recording/reproducing of digital information and a circuit with a simple hardware therefor.

Recently, a recording/reproducing apparatus adopting a digital mode has been widely used. In the apparatus, analog video and audio signals are converted into digital signals, and recorded on a magnetic recording medium through source encoding and channel encoding processes. The digital signal recorded on the magnetic recording medium is reproduced through channel decoding and source decoding processes.

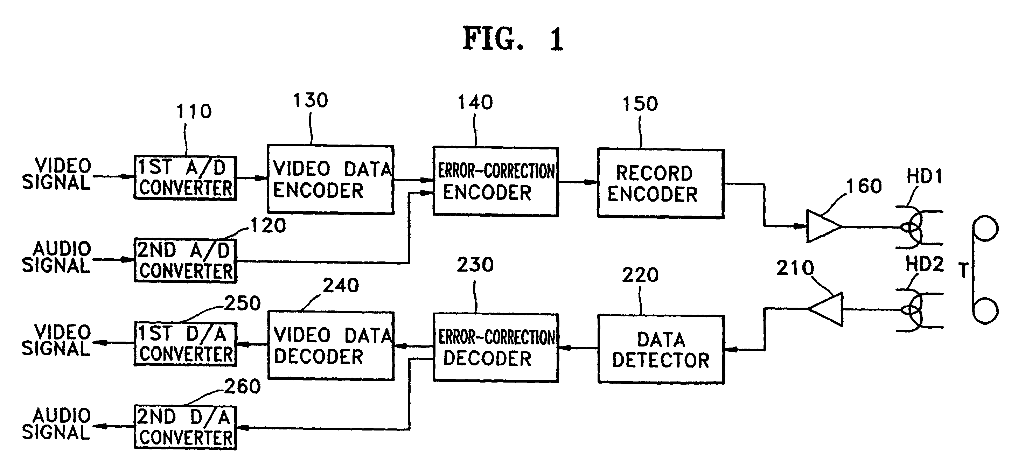

Figure 1 is a block diagram of a signal processing system in a digital videocassette recorder.

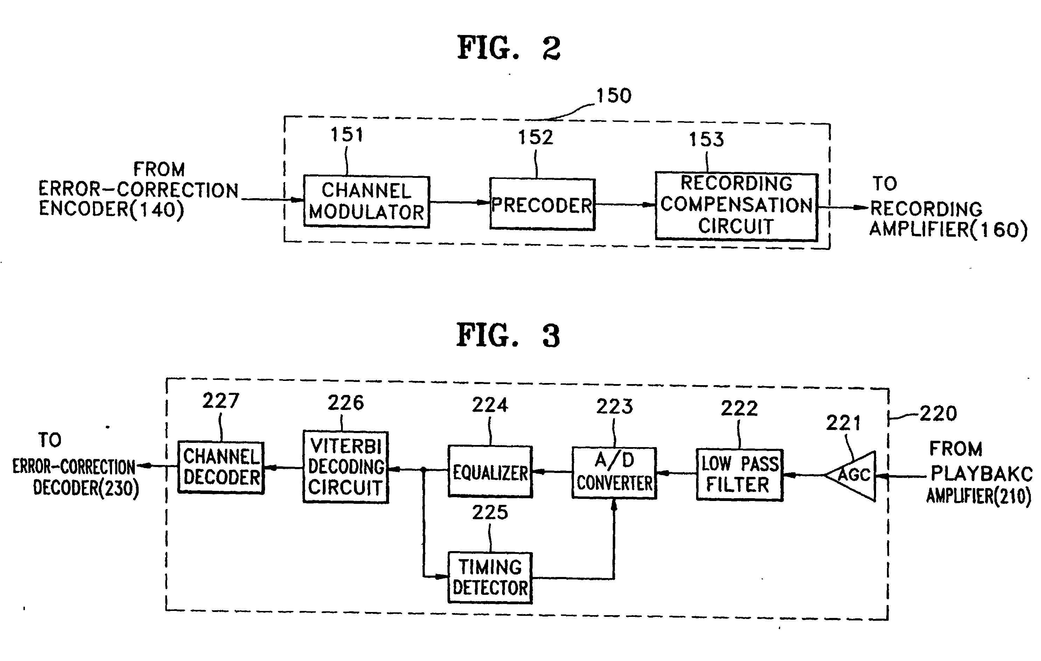

In Figure 1, analog video and audio signals are converted into digital signals in first and second analog-to-digital (A/D) converters 110 and 120, respectively. The video data are compressed by a high-efficiency code in a video data encoder 130 and then output to an error-correction encoder 140. The error-correction encoder 140 synthesizes the video data output from the video data encoder 130 and the audio data passed through the second A/D converter 120, and adds a parity to the data using an error correction code such as a Reed Solomon (RS) code to output the result to a recording encoder 150. The configuration of the recording encoder 150 is shown in Figure 2.

A channel modulator 151 shown in Figure 2 modulates the error-correction-coded data output from the error-correction encoder 140 shown in Figure 1, using an 8-to-14 or 24-to-25 modulation scheme. A precoder 152 converts the channel-modulated data into a non-return-to-zero inversion (NRZI) code. A recording compensation circuit 153 including a recording equalizer equalizes the NRZI code so as to compensate for the deterioration of recording characteristics and outputs the result to a recording amplifier 160 shown in Figure 1. Here, the recording equalizer may not be included in the recording compensation circuit 153.

The recording amplifier 160 amplifies the output signal of the recording encoder 150, and a recording magnetic head (HD1) records the amplified signal on a magnetic tape (T).

On the other hand, the signal recorded on the magnetic tape is read out by a playback magnetic head (HD2) and amplified by a playback amplifier 210. Then, a data detector 220 detects video and audio data from the amplified signal. The internal structure of the data detector 220 having a reproduction equalizer is shown in Figure 3.

An automatic gain control (AGC) amplifier 221 shown in Figure 3 adjusts the amplitude of the signal amplified by the playback amplifier 210 shown in Figure 1. A low-pass filter 222 filters the signal output from the AGC amplifier 221 to remove any high-frequency noise. Then, an A/D converter 223 converts the low-pass-filtered signal into digital data, and an equalizer 224 compensates for distortion in the waveform and level of the digital data and outputs the result to a Viterbi decoding circuit 226. A timing detector 225 detects a predetermined frequency of the equalized signal output from the equalizer 224 and a timing of the reproduced signal using a phase-locked loop (PLL) circuit (not shown) included therein, and outputs a sampling clock for the A/D converter 223 and a driving clock (not shown) for each portion of the reproducing circuit. The Viterbi decoding circuit 226 Viterbi-decodes the equalized data. A channel decoder 227 decodes the Viterbi-decoded data based on the abovementioned modulation scheme and outputs the result to an error-correction decoder 230 shown in Figure 1.

The error-correction decoder 230 corrects the errors of the video and audio data output from the data detector 220, and a video data decoder 240 decodes the video data output from the error-correction decoder 230. Then, the video and audio signals are restored in first and second digital-to-analog converters 250 and 260, respectively.

Meanwhile, for increasing the recording density of a signal without a significant change in the characteristics of the conventional recording/reproducing system, technologies related with partial response maximum likelihood, including a Viterbi decoding process, has been advanced, and a lot of specific circuits have been suggested.

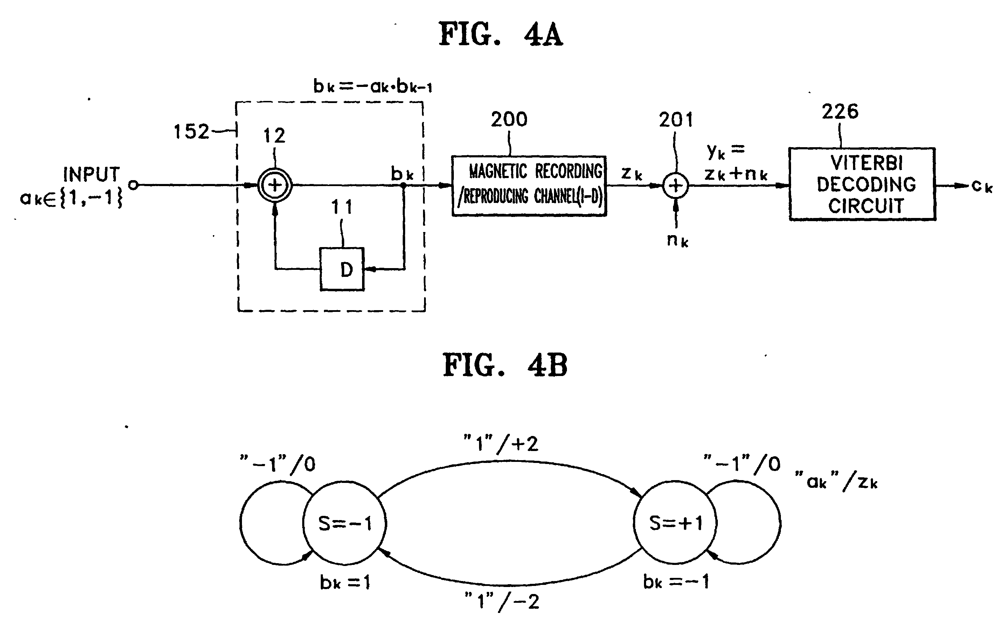

An application example of the Viterbi decoding process using the NRZI code having two states is shown in Figure 4A. In Figure 4A, reference numerals 152 and 226 represent a precoder and Viterbi decoding circuit, respectively, wherein the reference numerals are the same as those given to the precoder and Viterbi decoding circuit shown in Figures 2 and 3.

In Figure 4A, the precoder 152 is constituted of a delay 11 and a modulo-2 adder 12 which consists of an exclusive OR gate, and converts the input data into the NRZI code. This precoder 152 is called "1T precoder" or "PR(1,-1) type system."

A magnetic recording/reproducing channel 200 has a differential characteristic (1-D). An adder 201 is included for mathematical modelling of additive Gausian noise introduced in the channel. A channel output $y_k$ overlapped with noise $n_k$ can be represented by equation (1), and the channel output $y_k$ is input to the Viterbi decoding circuit 226 to obtain decoded output $c_k$.

$$y_k = z_k + n_k \text{ (if } n_k=0, \ y_k=z_k) \qquad (1)$$

Thus, in Figure 4A, $a_k$ is input data (binary coded information which is -1 or 1) at time $k$, D is a delay operator for 1-bit delay, $b_k$ is output data of the precoder 152 at time $k$, $z_k$ is output data of the magnetic recording/reproducing channel 200 which introduces no noise, (1-D) is the differential characteristic of the magnetic recording/reproducing channel 200, $n_k$ is a noise which is being overlapped to the data in the channel, $y_k$ is an input signal of receiving port of a Viterbi decoding circuit 220, and $c_k$ is the decoded data.

Figure 4B is a state diagram for the precoder 152, wherein arrows represent allowable transition from one state to another or to itself. And, $S$ indicates a state of the precoder.

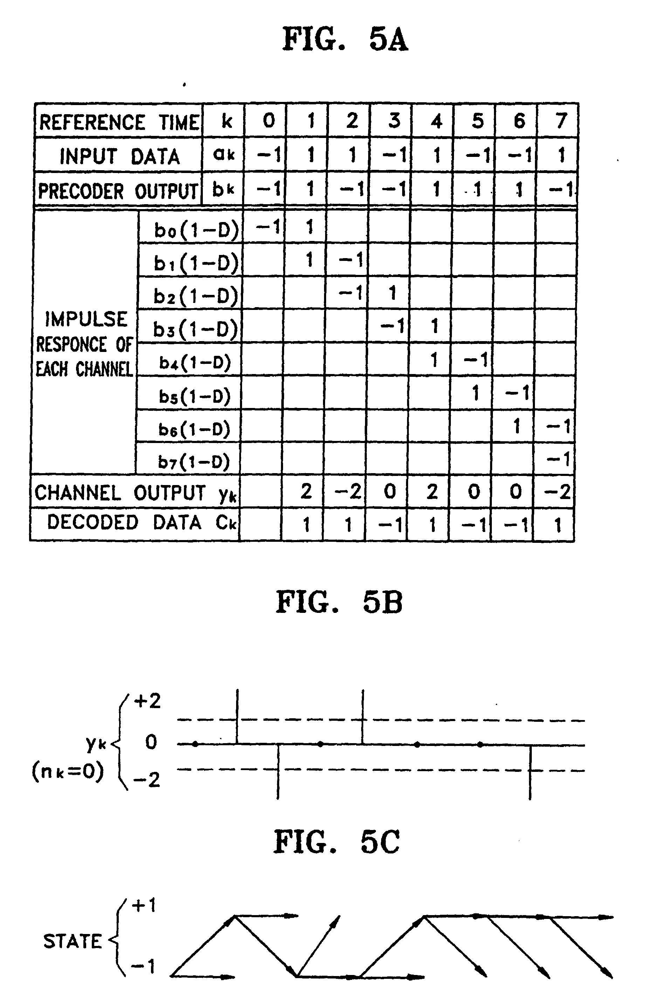

The process of obtaining the decoded data, when the data $a_k$ (-1 or 1) is being input to the precoder 152, is summarized in Figure 5A.

Figure 5B schematically shows the channel output $y_k$ input to the receiving port of the Viterbi decoder when no noise is overlapped in the channel and Figure 5C is a trellis diagram showing the state transition of $y_k$.

However, some noise is overlapped in the output signal of the equalizer 224 which is input to the Viterbi decoding circuit 226 shown in Figure 3. Here, the noise results primarily from the granularity of the particles on a tape, a head impedance and an initial bias resistance of a playback amplifier and the like. Since the reproduced signal overlapped with noise pass through various devices such as playback head HD2, playback amplifier 210, equalizer 224, etc., the spectra of the input signal and overlapped noise are varied when they reach the Viterbi decoding circuit 226.

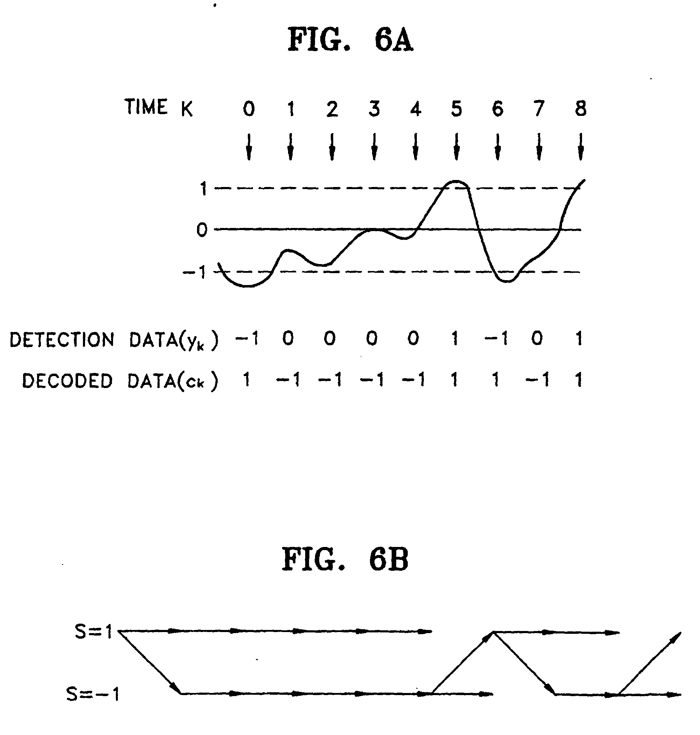

As shown in Figure 6A, the actual waveform of input signal to the Viterbi decoding circuit is an analog waveform in which the input data and the overlapped noise cannot be completely separated and identified from one another.

Thus, positive direction amplitude of the normalized inputs (+1, 0, -1) is quantized as one of two values "H" and "L" by an $H_n$ detecting comparator (not shown). Here, the output $H_n$ of the $H_n$ detecting comparator outputs "H" when the input signal is above the threshold "+1", and the output $H_n$ of the $H_n$ detecting comparator outputs "L" when the input signal is below the threshold "+1".

In the same manner, negative direction amplitude of the normalized inputs (+1, 0, -1) is quantized as one of two values "H" and "L" by $L_n$ detecting comparator (not shown). Here, the $L_n$ is "H" when the input signal is below the threshold "-1", and the $L_n$ is "L" when the input signal is above the threshold "-1".

Here, due to the differential characteristic (1-D) of the magnetic recording/reproducing channel and the decoding circuit of the partial response type PR(1,-1), "0"($H_n$=L) or "-1"($L_n$=H) is read out after "+1"($H_n$=H) if no noise is overlapped. That is, "+1" is never read out after "+1". Similarly, "0"($L_n$=L) or "+1"($H_n$=H), not "-1" ($L_n$=H), is read out after "-1"($L_n$=H).

Figure 6B is a trellis diagram of binary states illustrating operation of the Viterbi decoding circuit which receives the signal shown in Figure 6A.

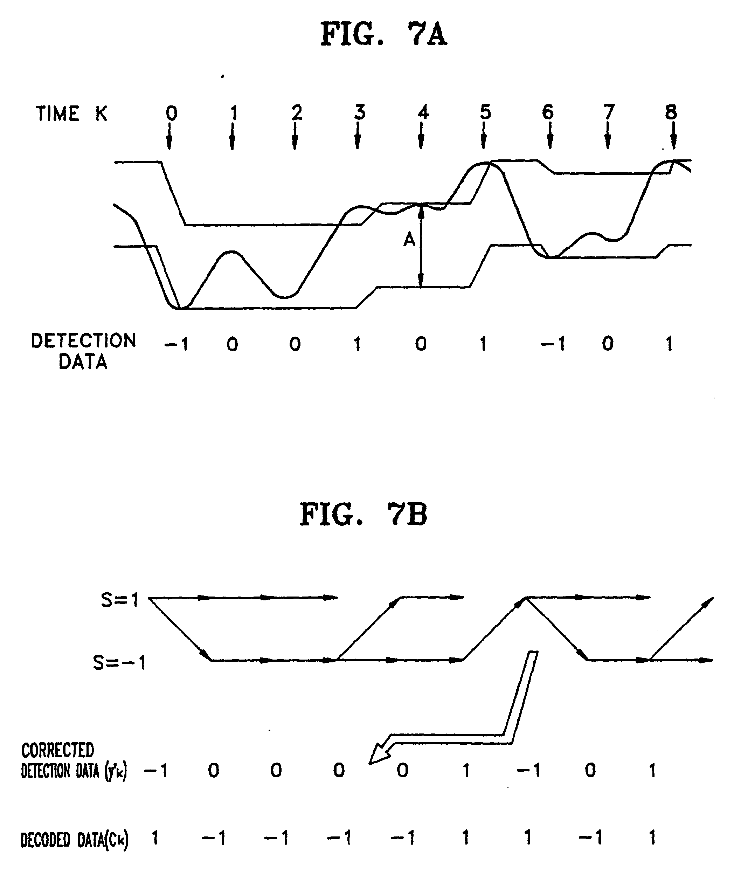

On the contrary, as shown in Figure 7A, when noise is overlapped in the channel output which is input to the Viterbi decoding circuit, the above described principle may not be satisfied.

Figure 7A shows an example of error due to the noise, in the sense that "+1" is detected again at k=5 after "+1" is detected at k=3.

Since the decoding circuit is of the partial response type PR(1, -1), it can be said, based on the above-described principle, that the signal is corrupted by noise when "+1" is read out after "+1" or "-1" is read out after "-1" regardless of zeros therebetween.

Here, during the Viterbi decoding process, as an index for determining what the detected data is precisely or which pass through the trellis diagram is most probable, metrics for each path are calculated to select a surviving path, and information of the surviving path is stored in a memory. As a result, the input data is decoded by reading data of a final surviving path from the memory. For this process, devices such as an A/D converter, a microprocessor, an adder, etc., are required.

However, if the states are binary, a peak value of the signal in the positive direction (hereinafter, simply "positive peak") and a peak value of the signal in the negative direction (hereinafter, simply "negative peak") basically correspond to the metrics. Thus, it is preferable to design a circuit which can detect the positive peak of the signal for maintaining the level of that value as a new threshold to detect consecutive positive peaks, and for updating a threshold for detecting the negative peak.

Here, the new threshold for detecting the negative peak should be lower than the threshold for detecting the positive peak by a predetermined value A.

If a circuit is constituted as above, the minimum distance of the metric is determined when the negative peak is detected after the detection of the positive peak. Further, a path, on the trellis diagram, to a time point of the previous positive peak which is the nearest from the negative peak, is determined at that moment. That is, a path having the minimum metric value is selected.

Similarly, the negative peak is detected and maintained. The detected value is set as a new threshold for detecting "-1" and simultaneously used to correct the "+1" detection threshold which is higher than "-1" detection threshold by the offset value A, for preparing the detection of the next positive peak or the next negative peak of the input signal.

A research for the interlocking of peak-to-peak value of the input signal with a predetermined offset value between the "-1" and "+1" threshold values is described in an article entitled *"signal processing method PRML, achieving large capacity memory device of* the next *generation"* in *Japan Nikkei Electronics*, No. 599, pp. 72-97, Jan., 1994.

An article "Dynamic threshold implementation of the maximum - likelihood detector for the EPR4 channel" by K.J. Knudson, J.K. Wolf and L.B. Milstein presented at IEEE Global Telecommunications Conference 1991; Vol 3, pp. 2135-2139, Dec., 1991 describes a dynamic threshold method for Viterbi detection using eight thresholds. the thresholds are grouped into four threshold pairs, where the distance between the thresholds in each pair is constant, and the article gives an algorithm for updating the thresholds and their interdependence based on three parameters. The threshold updating depends on the current thresholds and the current received sample, and on part thresholds and part received samples. The three parameters are defined in terms of state metrics.

An article "A block processing method for designing high-speed Viterbi detectors"" by H.K. Tahpar and J.M. Cioff; presented at IEEE International Conference on Communications 1989, Vol. 2, pp. 1096-1100, June, 1989 describes a block processing method for the Viterbi algorithm, and an implementations for such a block processing method including a modular layered architecture requiring replication and suitable interconnection of a plurality of add-compare-select modules for backward recursion. The achievable data rate may be increased by adding more layers of modules at the cost of increased hardware requirements.

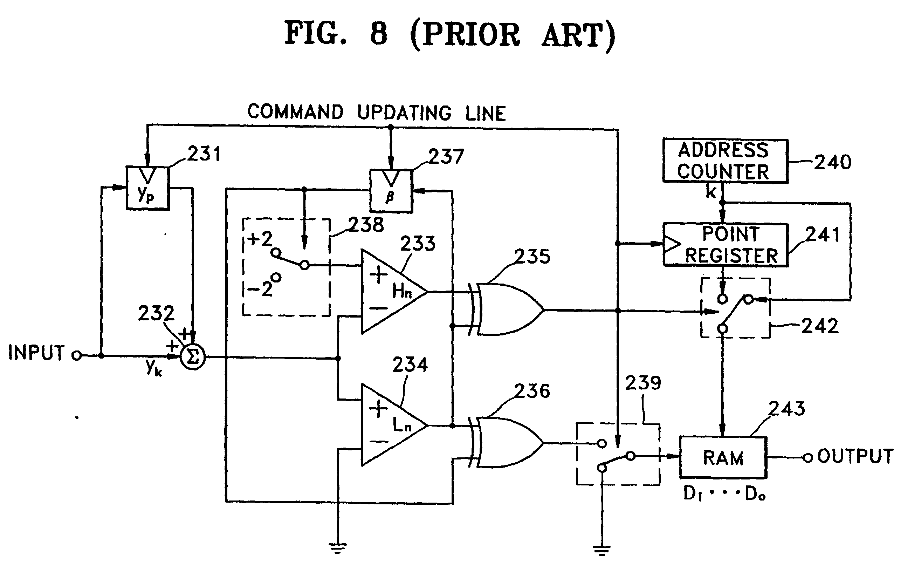

Referring to Figure 8, the structure of the conventional Viterbi decoding circuit will be described. Figure 8 shows a typical Viterbi decoding circuit which is described in articles entitled *"Optimal Reception for Binary Partial* Response *Channels"* by *M.J.Ferguson* in *Journal of Bell Syst. Tech. J.*, 51(2), pp. 493-505, Feb., 1972, and *"Viterbi Detection of Class IV Partial Response on a Magnetic Recording Channel"* by *R.W. Wood* and *D.A.Petersen* in *IEEE Trans. Comm.*, Vol. Com-34, No. 5, pp. 454-461, May, 1986.

In Figure 8, the input signal, which is quantized in an analog-to-digital (A/D) converter (not shown), is input to an adder 232 as data of -2, 0 or +2. A sample-hold device 231 updates or holds the input data depending on a signal output from an exclusive OR gate 235. That is, when the state of the input data is changed, the input data is updated, however, when the input data is not changed, the input data is held without change.

When the exclusive OR gate 235 outputs "1", which represents a change in state of the input data, the output of an exclusive OR gate 236 is written in a point address of a RAM 243 as "+1(H)", the point address being counted by an address counter 240 via a point register 241. Also, when the output of the exclusive OR gate 235 is "0", "-1(L)" is written in an address of the RAM 243, the address being counted by the address counter 240. Thus, the decoded data is accumulated in the RAM 243.

Here, it is preferable that an original input data $a_k$ and a decoded data $c_k$ of the NRZI are decoded as "+1(H)" and "-1(L)" when the state S is changed and unchanged on the trellis diagram, respectively, as shown in Figure 7B. Thus, in the latter case, the decoded result is written in the RAM 243 as "-1(L)" unconditionally.

On the other hand, as each new divergent point is established, one of the two existing paths is terminated. That is, each divergent point represents a new ambiguous bit as well as a point where some preceding ambiguity is settled. Thus, if the path diverges at time P, a final surviving path from the previous time p is determined at the next divergent point. Here, a transition of the state S at time p is known and then "+1(H)" or "-1 (L)" is written in the address p of the RAM 243 in response to the state transition.

Also, when performing the Viterbi decoding on the trellis diagrams, it is required to compute the metric at each divergent point using a microprocessor and to store the result.

Thus, an A/D converter and a microprocessor (CPU) which are not shown here as well as the RAM and the address counter are needed for the above structure.

As described above, when constructing the Viterbi decoding circuit using a RAM, an A/D converter and a digital signal processor including a microprocessor, a digital adder, etc. are required.

When the Viterbi decoding circuit is made into an integrated circuit (IC), chip size increases due to the addition of the A/D converter and the digital signal processor and the manufacturing cost increases as well. Particularly, 64 comparators should be installed in a 6-bit flash type A/D converter adopted in a conventional Viterbi decoding circuit, thereby increasing the chip area.

With a view to solving or reducing the above problem, it is an aim of preferred embodiments of the present invention to provide a Viterbi decoding method in which a Viterbi decoding is performed from right to left (reverse direction) in the trellis diagram, so that the Viterbi decoding can be performed simply without the complicated operations which are performed at every divergent point in the conventional method.

It is another aim of embodiments of the present invention to provide a Viterbi decoding circuit with a simple hardware by adopting a shift register memory (shift register) as a main circuit component instead of an A/D converter and microprocessor for a metric operation.

According to a first aspect of the invention, there is provided a Viterbi decoding method for decoding an input signal comprising the steps of: (a) detecting instantaneous values of negative and positive peak data as alternatives of metrics from the input signal; (b) grouping the detected instantaneous values by a predetermined time and outputting grouped positive and negative peak data; (c) converting the grouped positive and negative peak data in the reverse direction and outputting reverse positive and negative data; (d) Viterbi-decoding the positive and negative peak data with respect to initial states of a predetermined number and outputting the reverse decoded data of a predetermined number of channels; (e) converting the reverse decoded data of each channel into forward direction and outputting the forward decoded data of channels of a predetermined number; and (f) selecting one of the forward decoded data of the channels based on the states of initial decoded data of the next group and outputting the selected data as a final decoded data.

Preferably, said step (f) comprises the step of delaying forward decoded data of a predetermined number of channels until the state of the initial decoded data of the next group is determined.

Said predetermined number of channels may be two.

Preferably, the number of bits in each group is determined by a digital modulation method.

According to a second aspect of the invention, there is provided a Viterbi decoding method for demodulating a reproduced signal in a magnetic recording/reproducing apparatus comprising the steps of:

(a) comparing the reproduced signal with each of positive and negative peak thresholds to obtain binary encoded data in the positive (positive peak data) and negative (negative peak data) amplitude directions;

(b) grouping the positive and negative peak data by a predetermined time and outputting grouped positive and negative peak data;

(c) Viterbi-decoding the grouped positive and negative peak data and outputting the Viterbi-decoded data; and

(d) concatenating final decoded data of the present group and initial decoded data of the next group to de-group the decoded data.

Said step (c) may comprise the steps of:

(c1) converting the grouped positive and negative peak data in the reverse direction and outputting reverse positive and negative peak data;

(c2) Viterbi-decoding the reverse positive and negative peak data with respect to two initial states and outputting reverse decoded data of two channels; and

(c3) converting the reverse decoded data of two channels in the forward direction and outputting forward decoded data of two channels.

Said step (d) may comprise the steps of:

(d1) determining a state of initial decoded data of the next group connected to the final decoded data of the present group; and

(d2) selecting one of the forward decoded data of two channels based on the determined state value to de-group the decoded data.

Said step (c) may further comprise the step of (c4) delaying the forward decoded data of two channels until the state value of first decoded data of the next group is determined.

The number of bits in each group is preferably determined by a digital modulation method.

According to a third aspect, there is provided a Viterbi decoding circuit for decoding an input signal comprising:

detecting means for detecting instantaneous values of positive and negative peaks as alternatives of metrics from the input signal;

first converting means for grouping the detected instantaneous data by a predetermined time and converting grouped positive and negative peak data in the reverse direction to output reverse positive and negative peak data;

Viterbi decoding means for Viterbi-decoding the reverse positive and negative peak data with respect to initial states of a predetermined number to output reverse decoded data of a predetermined number of channels, and for outputting a selection control signal based on the state of initial decoded data of the next group connected to final decoded data of the present group;

second converting means for converting the reverse decoded data of the predetermined number of channels in the forward direction and outputting forward decoded data of the predetermined number of channels; and

selecting means for selecting one of forward decoded data of the predetermined number of channels responding to the selection control signal and outputting a final decoded data.

The number of channels is preferably two.

Said first converting means preferably comprises a serial-input/parallel-output type shift register memory and a parallel-input/serial-output type shift register memory.

Said second converting means preferably comprises a serial-input/parallel-output type shift register memory and a parallel-input/serial-output type shift register memory.

Said Viterbi decoding means preferably comprises:

an initial state setting circuit for setting first and second initial states for each group;

a first decoding logic circuit for performing a logic operation with respect to the first initial state and the reverse positive and negative peak data, respectively, to output a first reverse decoded data Viterbi-decoded with respect to the first initial state;

a second decoding logic circuit for performing a logic operation with respect to the second initial state and the reverse positive and negative peak data, respectively, to output a second reverse decoded data Viterbi-decoded with respect to the second initial state; and

a selection control signal generating circuit for generating a selection control signal based on the decoded value of the initial decoded data of the next group connected to the final decoded data of the group output from said first decoding logic circuit.

Said selecting means may comprise:

first and second shift registers for delaying the forward decoded data of two channels until the selection control signal is generated; and

a switching device for selecting one of the outputs of said first and second shift registers according to the selection control signal.

Preferably, the number of bits in each group is determined by a digital modulation method.

According to a further aspect of the invention, there is provided a Viterbi decoding circuit for demodulating a reproduced signal in a magnetic recording/reproducing apparatus comprising:

peak detecting means for interlocking positive and negative peak detecting thresholds to maintain the difference between two thresholds as a predetermined offset value and detecting instantaneous values of positive and negative peaks of the reproduced signal to output positive and negative peak data;

first reverse converting means for grouping positive peak data output from said peak detecting means by a predetermined time and converting the grouped positive peak data in the reverse direction to output a reverse positive peak data;

second reverse converting means for grouping negative peak data output from said peak detecting means by a predetermined time and converting the grouped negative peak data in the reverse direction to output a reverse negative peak data;

Viterbi decoding means for Viterbi-decoding the reverse positive and negative peak data output from said first and second reverse converting means with respect to the first and second initial state values to output reverse decoded data of two channels, and for outputting a selection control signal based on the state of the initial decoded data of the next group connected to the final decoded data of the present group;

first forward converting means for converting reverse decoded data which is decoded with respect to the first initial state in the forward direction to output a first forward decoded data;

second forward converting means for converting a second reverse decoded data which is decoded with respect to the second initial state value in the forward direction to output second forward decoded data; and

selecting means for selecting one of first and second forward decoded data responding to the selection control signal to output the selected decoded data.

The circuit may further comprise an amplifier for amplifying the reproduced signal to output the amplified signal to said peak detecting means.

Said peak detecting means preferably comprises two comparators for comparing the reproduced signal with positive and negative peak thresholds, respectively, to output encoded binary data in the positive (positive peak data) and negative (negative peak data) amplitude directions.

Said first and second reverse converting means may comprise a serial-input/parallel-output type shift register memory and a parallel-input/serial-output type shift register memory.

Said first and second forward converting means may comprise a serial-input/parallel-output type shift register memory and a parallel-input/serial-output type shift register memory.

Said Viterbi decoding means may comprise:

an initial state setting circuit for setting first and second initial states for each group;

a first decoding logic circuit for performing a logic operation with respect to the first initial state and the reverse positive and negative peak data, respectively, to output a first reverse decoded data Viterbi-decoded with respect to the first initial state;

a second decoding logic circuit for performing a logic operation with respect to the second initial state and the reverse positive and negative peak data, respectively, to output a second reverse decoded data Viterbi-decoded with respect to the second initial state; and

a selection control signal generating circuit for generating a selection control signal based on the decoded value of the initial decoded data of the next group connected to the final decoded data of the group output from said first decoding logic circuit.

Said selecting means preferably comprises:

first and second shift registers for delaying the first and second forward decoded data until the selection control signal is generated; and
a switching device for selecting one of the outputs of said first and second shift registers responding to the selection control signal.

For a better understanding of the invention, and to show how embodiments of the same may be carried into effect, reference will now be made, by way of example, to the accompanying diagrammatic drawings, in which:

Figure 1 is a block diagram of a signal processing system in a digital videocassette recorder;

Figure 2 is a diagram showing an example of the internal structure of a recording encoder shown in Figure 1;

Figure 3 is a diagram showing an example of the internal structure of a data detector shown in Figure 1;

Figure 4A is a diagram showing an example of the Viterbi decoding process using the NRZI code and Figure 4B is a state diagram of the precoder in Figure 4A;

Figure 5A is a table showing the decoding process, Figure 5B is a channel output diagram and Figure 5C is a trellis diagram in which the state transition of channel output is shown;

Figure 6A is a diagram showing the input signal of the Viterbi encoding circuit shown in Figure 3, and Figure 6B is a trellis diagram for the Viterbi decoding circuit;

Figure 7A is a diagram illustrating the input signal of the Viterbi encoding circuit and a correction process of the detection data when noise is overlapped, and Figure 7B is a trellis diagram for the Viterbi decoding circuit;

Figure 8 is a circuit diagram of a conventional Viterbi decoding circuit;

Figure 9 is a diagram showing an example of the internal structure of a data detector without the A/D converter;

Figure 10 is a block diagram of a Viterbi decoding circuit according to embodiments of the present invention;

Figure 11 is a detailed circuit diagram of the Viterbi decoding circuit shown in Figure 10; and

Figure 12 is a detailed circuit diagram of an initial state value setting and Viterbi decoder shown in Figure 11.

First, according to a Viterbi decoding method of the present invention, the Viterbi decoding is performed in the reverse direction of a state transition diagram, so that paths are joined at each divergent point. As a result, there is no reason for storing metric operation results in a memory according to each state. That is, the operation by the microprocessor and the memory for storing the result are not necessary. Also, the path on the state transition diagram can be determined by an instantaneous value obtained from the detection of a positive or negative peak.

The input signal is divided by a predetermined time and grouped. For decoding in the reverse direction, positive and negative peaks of the input signal by a group are detected instead of calculating the metrics and then processed in the reverse direction. The reverse Viterbi-decoded data of two channels are generated at the same time in consideration of the state of initial decoded data of the next group connected to the final decoded data of the present group, and then converted into the forward Viterbi-decoded data. Then, the forward Viterbi-decoded data of the two channels are delayed in parallel until the state of initial decoded data of the next group is determined. When the state of the initial decoded data of the next group is determined, one of the delayed forward Viterbi-decoded data of the two channels is selected to output the decoded data.

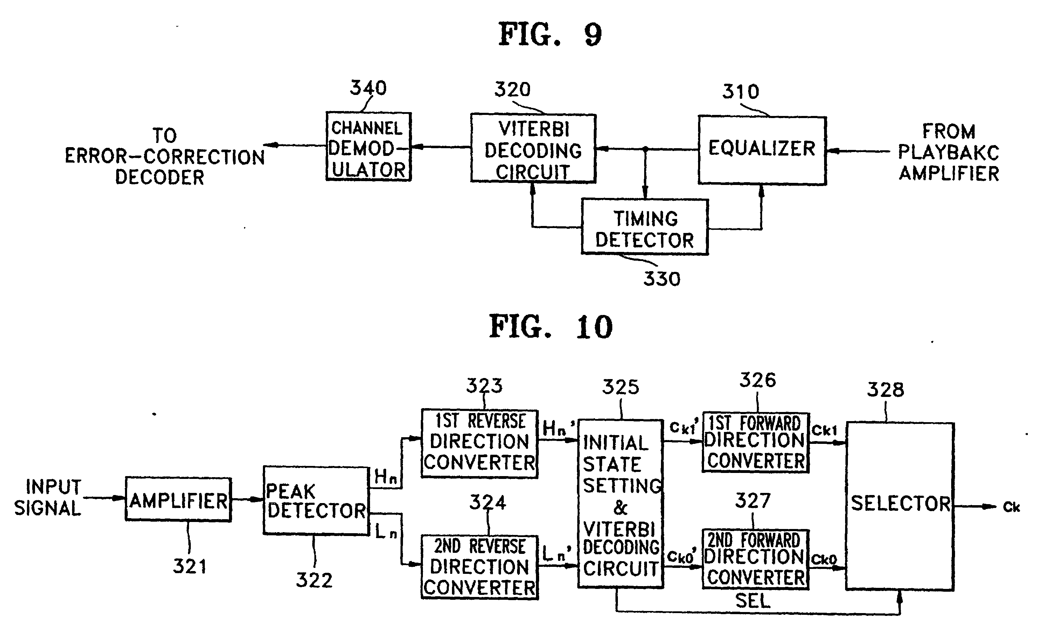

Figure 9 is a block diagram of the data detector adopting the Viterbi decoding circuit of the present invention. The A/D converter is not employed in the data detector. However, the present invention can be applied to the data detector 220 shown in Figure 3.

In Figure 9, an equalizer 310 equalizes the data reproduced from a playback amplifier and outputs the result to a Viterbi decoding circuit 320. A timing detector 330 detects the timing of the reproduced signal from the output of the equalizer 310 and outputs driving clocks required for the equalizer 310 and Viterbi decoding circuit 320 and for other portions which are not shown in Figure 9. The Viterbi decoding circuit 320 performs the Viterbi decoding of the equalized data. A channel demodulator 340 demodulates the Viterbi-decoded data based on the modulation scheme and outputs the result to an error-correction decoder. Here, the equalizer 310 may be either a fixed or adaptive type.

Figure 10 is a block diagram of the Viterbi decoding circuit 320 shown in Figure 9 which adopts a shift register as a main component.

In Figure 10, an amplifier 321 amplifies the equalized signal output from the equalizer 310 shown in Figure 9.

A peak detector 322 interlocks the positive and negative peak detection thresholds to maintain the difference between the above two thresholds as an offset value A. While maintaining the difference, the peak detector 322 detects the positive and negative peaks of the signal amplified from the amplifier 321.

A first reverse direction converter 323 groups positive peak data $H_n$ output from the peak detector 322 by a predetermined number of bits (here, 8 bits), and then performs the reverse direction converting for the grouped data to detect the positive peak data in the reverse direction.

A second reverse direction converter 324 groups negative peak data $L_n$ output from the peak detector 322 by a predetermined number of bits (here, 8 bits), and then performs the reverse direction converting for the grouped data to detect the negative peak data in the reverse direction.

An initial state setting and Viterbi decoding circuit (hereinafter referred to as only "decoder") 325 receives the reverse positive and negative peak data $H_n'$ and $L_n'$ output from the first and second reverse direction converters 323 and 324, decodes the data under the initial condition of two states ($S_1$=1 and $S_0$=-1), and then outputs decoded data $c_{k1}'$ and $C_{k2}'$ to two separate channels. Further, the decoder 325 outputs a selection control signal SEL based on the state of the initial decoded data of the next group following the final decoded data of the present group.

A first forward direction converter 326 converts the positive peak data in the reverse direction $c_{k1}'$ which was decoded under the initial condition of $S_1$=1 and output from the decoder 325, into the forward direction to output a forward decoded data $c_{k1}$.

A second forward direction converter 327 converts the negative peak data in the reverse direction $c_{k0}'$ which was decoded under the initial condition of $S_o$=-1 and output from the decoder 325, into the forward direction to output a forward decoded data $c_{k0}$.

A selector 328 delays the forward decoded data $c_{k1}$ and $c_{k0}$, output from the first and second forward direction converters 326 and 327, until the state of the initial decoded data of the next group is determined. And then, the selector 328 selects one of the delayed forward decoded data $c_{k1}$ and $c_{k0}$ which is correct, responding to the selection control signal (SEL) output from the decoder 325, wherein the selection control signal reflects the determined state of the initial decoded data of the next group, to output a decoded data $c_k$.

This block diagram constituted as above addresses the following problems.

As can be seen in the trellis diagram shown in Figure 5C, when the signal is decoded from left to right (forward direction) on the trellis diagram, it is necessary to calculate the metric for determining the surviving path at divergent point. Thus, the microprocessor should compute the metrics of various paths at each divergent point. However, when the Viterbi decoding is performed in the reverse direction, that is, from right to left, on the trellis diagram of Figure 5C having two states, the decision made at each state is obviated since there is only one path.

For example, as shown in the trellis diagram of Figure 7B, if the signal is decoded from the time k=7 to k=0 in sequence, the correct data can be precisely detected.

In this case, it is necessary to check the metric at each state. However, if the positive and negative peaks of the input signal are detected, it is not required to compute the metric by the microprocessor since the positive and negative peak detections correspond to the calculation of the metrics in nature.

Thus, if the positive and negative instantaneous peaks are detected as the values corresponding to the metrics and the result is stored as the positive and negative peak data $H_n$ and $L_n$, the path on the trellis diagram can be determined. For example, when the decoding process starts from the time point where k=7, the state $S(7)$ at k=7 is determined depending on the state $S(8)$ at k=8. Therefore, the decoder 325 generates the reverse Viterbi-decoded data $c_{k1}'$ and $c_{k2}'$ in parallel under the assumption that $S(8)=S_1=1$ and $S(8)=S_0=-1$, respectively.

The reverse decoded data $c_{k1}'$ based on the initial state $S_1$ and the reverse decoded data $c_{k0}'$ based on the initial state $S_0$ are input to a shift register for alternative conversion to the forward direction in sequence, and then aligned in the forward direction to output the forward decoded data $c_{k1}$ and $c_{k0}$ processed through the alternative conversion process.

Thereafter, until the state $S(8)$ is determined by the decoder 325, the selector 328 delays the forward decoded data $c_{k1}$ and $c_{k0}$ in parallel. When the state $S(8)$, which is $S_1$ or $S_2$, is determined, the selector 328 selects one of the delayed forward decoded data $c_{k1}$ and $c_{k0}$ to output the decoded data $c_k$.

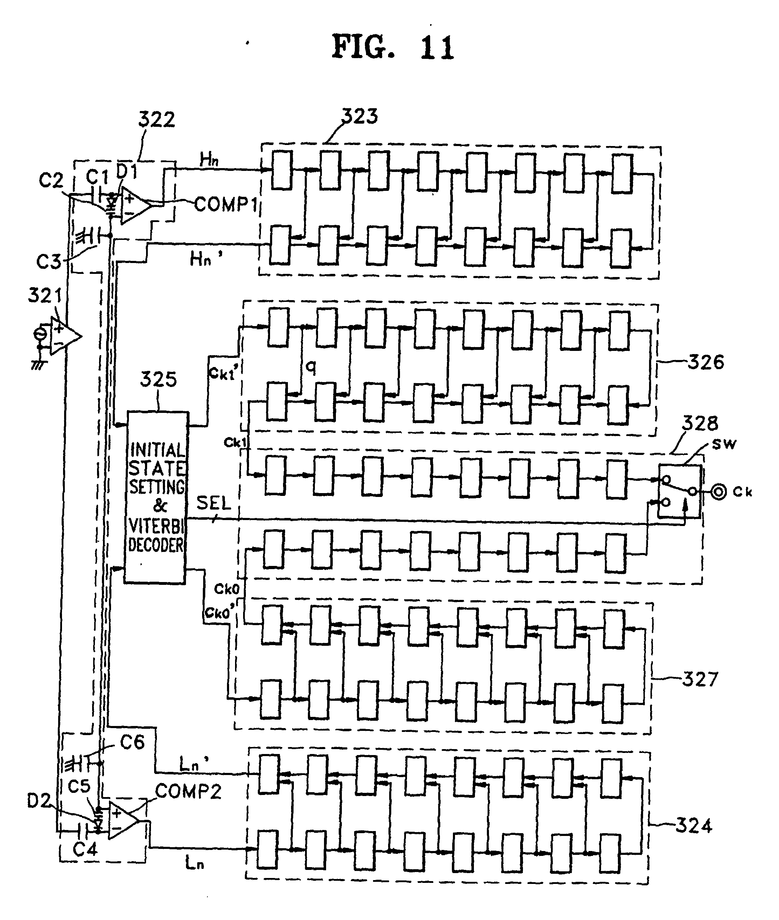

The Viterbi decoding circuit shown in Figure 10 will be described in detail in relation with Figure 11.

In Figure 10, the amplifier 321 is a buffering amplifier that amplifies the input signal to a predetermined signal level required for the peak detector 322.

The peak detector 322 includes a comparator COMP1 for detecting the positive peak data $H_n$ and a comparator COMP2 for detecting the negative peak data $L_n$. The non-inverting port of the comparator COMP1 is commonly connected to a capacitor C1 which is also connected to the output port of the amplifier 321, and to the anode of a diode D1. One port of a capacitor C2 is connected to the cathode of the diode D1 and the other port thereof is commonly connected to a grounded capacitor C3 and the inverting port of the comparator COMP1. The inverting port of the comparator COMP2 is commonly connected to a capacitor C4 which is also connected to the output port of the amplifier 321 and the cathode of the diode D2. One port of a capacitor C5 is connected to the anode of the diode D2 and the other end thereof is commonly connected to a grounded capacitor C6 and the non-inverting port of the comparator COMP2.

The peak detector 322 interlocks the thresholds for detection of positive and negative peaks, and maintains the difference between two thresholds at a predetermined offset value A, to stabilize both positive and negative peaks.

The first and second reverse direction converters 323 and 324 are formed of a combination of two 8-bit shift registers, i.e., one serial-input/parallel-output type and one parallel input/serial output type, for converting the positive peak data $H_n$ and the negative peak data $L_n$, respectively.

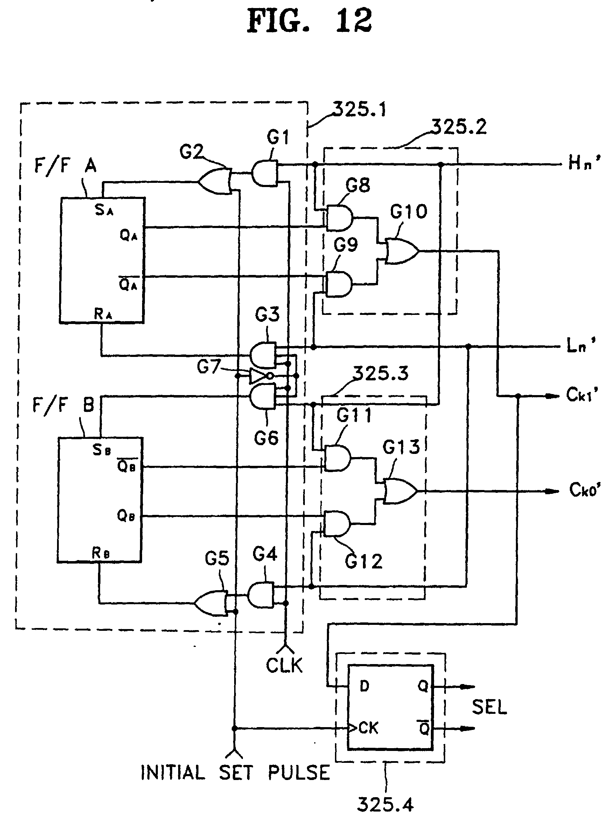

Figure 12 is a detailed circuit diagram of the decoder 325. As shown in Figure 12, in order to set the output $Q_A$ of a RS flip-flop F/F *A* to "H" corresponding to an initial state $S_1$, an initial setting pulse is applied to the set input $S_A$ via an OR gate G2. Similarly, to set the output $Q_B$ of a RS flip-flop F/F *B* to "L" corresponding to an initial state $S_0$, the initial setting pulse is applied to the reset input $R_B$ via an OR gate G5.

Here, the initial set pulse corresponds to a byte pulse generated by 8-bit period. An inverter G7 is provided to invert the initial setting pulse, so that logic high state is not applied to *S* and *R* inputs simultaneously.

Also, the reverse positive peak data $H_n$' is applied to the set inputs $S_A$ and $S_B$ of each RS flip-flop F/F A and F/F *B* via AND gates G1 and G6 according to the clock. Similarly, the reverse negative peak data $L_n$ is applied to the reset inputs $R_A$ and $R_B$ via AND gates G3 and G4 according to the clock.

An AND gate G8 performs a logic AND operation of the reverse positive peak data $H_n$' and the output $Q_A$ of the flip-flop F/F A, and an AND gate G9 performs a logic AND operation of the reverse negative peak data $L_n$' and the inverting output $\overline{Q}_A1$ of the flip-flop F/F A. An OR gate G10 performs a logic OR operation of the outputs of the AND gates G8 and G9.

An AND gate G11 performs a logic AND operation of the reverse positive peak data $H_n$' and the inverting output $\overline{Q}_B2$ of the flip-flop F/F *B*, and an AND gate G12 performs a logic AND operation of the reverse negative peak data $L_n$' and the output $Q_B$ of the flip-flop F/F *B*. An OR gate G13 performs a logic OR operation of the outputs of the AND gates G11 and G12.

Thus, the reverse decoded data $c_{k1}$' based on the initial state $S_1$ is output from the OR gate G10, and the reverse decoded data $c_{k0}$' based on the initial state $S_0$ is output from the OR gate G13.

Here, reference numeral 325.1 denotes an initial state setting circuit, reference numeral 325.2 denotes a first Viterbi logic circuit, reference numeral 325.3 denotes a second Viterbi logic circuit, and reference numeral 325.4 denotes a selection control signal generating circuit consisting of a D flip-flop.

The first forward direction converter 326 and the second forward direction converter 327 shown in Figure 11 are formed of the combination of two 8-bit shift registers, i.e., one serial-input/parallel output type and one parallel-input/serial-output type, respectively. The reverse decoded data $c_{k1}$' and $c_{k0}$' based on the initial states $S_1$ and $S_0$, respectively, are stored in respective serial-input/parallel-output type shift registers, and transferred to the parallel-input/serial-output type shift registers. When the decoded data are output from the parallel-input/serial-output type registers, they are arranged in the forward direction.

The selector 328 is comprised of two shift registers of serial-input/parallel-output type which delay the decoded data $c_{k1}$ and $c_{k0}$, and a switch SW constituted of a logic circuit for selecting one of the decoded data $c_{k1}$ and $c_{k0}$ depending on the selection control signal SEL output from the decoder 325.

The selection control signal SEL provided to the selector 328 shown in Figure 11 is generated from the flip-flop 325.4 shown in Figure 12. The reverse decoded data $c_{k1}$' which are Viterbi-decoded in the initial state $S_1$ by the decoder 325 and output from the OR gate G10 are input to the input port D of the D F/F. And the initial setting pulse is input to the clock port of the D F/F. The selection control signal SEL controls a switch SW so that the first selection port is selected when the output port Q is logic high and the second selection port is selected when the inverted output $\overline{Q}3$ is logic high.

Here, the initial setting pulse and clock required by the decoder 325 are generated from a signal generator (not shown) which generates an intended timing signal by receiving the driving clock output from timing detector 330 shown in Figure 9, or may be generated from timing detector 330 itself.

In addition, in order to simplify understanding of the operation of portions shown in Figures 11 and 12, an example of the decoding process will be described referring to the input signal and trellis diagrams shown in Figures 7A and 7B.

The input signal $y_k$ is divided by 8-bit and then processed in group units as follows:

$(y_0, y_1, y_2, y_3, y_4, y_5, y_6, y_7), (y_8, y_9, y_{10}, y_{11}, y_{12}, y_{13}, y_{14}, y_{15}), (y_{16}, y_{17}, y_{18}, y_{19}, y_{20}, y_{21}, y_{22}, y_{23}), ...$

Thus, the data is input to the decoder 325 in the reverse direction for each group, and output in the reverse direction as follows:

$(y_7, y_6, y_5, y_4, y_3, y_2, y_1, y_0), (y_{15}, y_{14}, y_{13}, y_{12}, y_{11}, y_{10}, y_9, y_8), (y_{23}, y_{22}, y_{21}, y_{20}, y_{19}, y_{18}, y_{17}, y_{16}), ...$

The state $S(8)$ at k=8 is determined when a group of signals including the input signal $y_8$ is Viterbi-decoded by the decoder 325 and $S(8)$ is input to the shift register of the serial-input/parallel output type of the first forward direction converter 326.

As a result, the time delay occurs during the Viterbi decoding process. That is, the time is delayed until the state of the final decoded data of the next group is determined. For example, in case that the data is divided by 8-bit and processed in the reverse direction, S (8) is determined in the last of third periods, the first forward decoded data under the initial state $S_1$ or the second forward decoded data under initial state $S_0$ is selected at the same time. Thus, a delay of 24 (8 bit$\times$3) bits.

However, if the clock frequency for the shift registers of reverse direction and forward direction converters, is increased, the time delay may be reduced.

On the other hand, the number of bits of each group is determined according to the digital modulation scheme. Particularly, the number of bits of each group should be determined considering a runlength limit (RLL) value to be set.

As described above, when the states are binary (S=1 or S=-1) and the decoding circuit is a partial response type of PR(1, -1), PR(1, 1) or PR(1, 0, 1), it is preferable to design a decoding circuit by adopting a shift register as a main circuit component without an A/D converter or microprocessor, wherein the shift register receives the positive and negative peak data. As a result, the size of the integrated circuit can be minimized and the manufacturing costs are reduced.

**Claims**

1. A Viterbi decoding method for decoding an input signal comprising the steps of:

   (a) detecting instantaneous values of negative and positive peak data as alternatives of metrics from the input signal;

   (b) grouping the detected instantaneous values by a predetermined time and outputting grouped positive and negative peak data;

   (c) converting the grouped positive and negative peak data in the reverse direction and outputting reverse positive and negative data;

   (d) Viterbi-decoding the reverse positive and negative peak data with respect to initial states of a predetermined number and outputting the reverse decoded data of a predetermined number of channels;

   (e) converting the reverse decoded data of each channel of the predetermined number of channels into forward direction and outputting the forward decoded data of channels of a predetermined number; and

   (f) selecting one of the forward decoded data of the predetermined number of channels based on the state of initial decoded data of the next group connected to final decoded data of the present group and outputting the selected data as a final decoded data.

2. A Viterbi decoding method as claimed in claim 1, wherein said step (f) comprises the step of delaying forward decoded data of a predetermined number of channels until the state of the initial decoded data of the next group is determined.

3. A Viterbi decoding method as claimed in claim 1 or 2, wherein said predetermined number of channels are two.

4. A Viterbi decoding method as claimed in claim 3, wherein said step (f) comprises the steps of:

   (f1) determining a state of initial decoded data of the next group connected to the final decoded data of the present group; and

   (f2) selecting one of the forward decoded data of two channels based on the determined state value to de-group the decoded data.

5. A Viterbi decoding method as claimed in claim 4, wherein said step (d) further comprises the step of (c4) delaying the forward decoded data of two channels until the state value of first decoded data of the next group is determined.

6. A Viterbi decoding method as claimed in any preceding claim wherein the number of bits in each group is determined by a digital modulation method.

7. A Viterbi decoding circuit for decoding an input signal comprising:

   detecting means (322) for detecting instantaneous values of positive and negative peaks as alternatives of metrics from the input signal;

   first converting means (323, 324) for grouping the detected instantaneous data by a predetermined time and converting grouped positive and negative peak data in the reverse direction to output reverse positive and negative peak data;

   Viterbi decoding means (325) for Viterbi-decoding the reverse positive and negative peak data with respect to initial states of a predetermined number to output reverse decoded data of a predetermined number of channels, and for outputting a selection control signal based on the state of initial decoded data of the next group connected to final decoded data of the present group;

second converting means (326, 327) for converting the reverse decoded data of the predetermined number of channels in the forward direction and outputting forward decoded data of the predetermined number of channels; and

selecting means (328) for selecting one of forward decoded data of the predetermined number of channels responding to the selection control signal and outputting a final decoded data.

**8.** A Viterbi decoding circuit as claimed in claim 7, wherein the number of channels is two.

**9.** A Viterbi decoding circuit as claimed in claim 7 or 8, wherein said first converting means (323, 324) comprises a serial-input/parallel-output type shift register memory and a parallel-input/serial-output type shift register memory.

**10.** A Viterbi decoding circuit as claimed in claim 7, 8, or 9, wherein said second converting means (326, 327) comprises a serial-input/parallel-output type shift register memory and a parallel-input/serial-output type shift register memory.

**11.** A Viterbi decoding circuit as claimed in claim, wherein said selecting means (328) comprises:

first and second shift registers for delaying the forward decoded data of two channels until the selection control signal is generated; and

a switching device (SW) for selecting one of the outputs of said first and second shift registers according to the selection control signal.

**12.** A Viterbi decoding circuit as claimed in claim 7, 8, 9, 10 or 11, wherein the number of bits in each group is determined by a digital modulation method.

**13.** A Viterbi decoding circuit for decoding a signal according to claim 7, said decoding circuit comprising part of a magnetic recording/reproducing apparatus and further comprising:

peak detecting means (322) for interlocking positive and negative peak detecting thresholds to maintain the difference between two thresholds as a predetermined offset value and detecting instantaneous values of positive and negative peaks of the reproduced signal to output positive and negative peak data;

first reverse converting means (323) for grouping positive peak data output from said peak detecting means (322) by a predetermined time and converting the grouped positive peak data in the reverse direction to output a reverse positive peak data;

second reverse converting means (324) for grouping negative peak data output from said peak detecting means (322) by a predetermined time and converting the grouped negative peak data in the reverse direction to output a reverse negative peak data;

Viterbi decoding means (325) for Viterbi-decoding the reverse positive and negative peak data output from said first and second reverse converting means (323, 324) with respect to the first and second initial state values to output reverse decoded data of two channels, and for outputting a selection control signal based on the state of the initial decoded data of the next group connected to the final decoded data of the present group;

first forward converting means (326) for converting reverse decoded data which is decoded with respect to the first initial state in the forward direction to output a first forward decoded data;

second forward converting means (327) for converting a second reverse decoded data which is decoded with respect to the second initial state value in the forward direction to output second forward decoded data; and

selecting means (328) for selecting one of first and second forward decoded data responding to the selection control signal to output the selected decoded data.

**14.** A Viterbi decoding circuit as claimed in claim 13, further comprising an amplifier (321) for amplifying the reproduced signal to output the amplified signal to said peak detecting means.

**15.** A Viterbi decoding circuit as claimed in claim 13 or 14, wherein said peak detecting means (322) comprises two comparators (COMF1, COMP2) for comparing the reproduced signal with positive and negative peak thresholds, respectively, to output encoded binary data in the positive (positive peak data) and negative (negative peak data) amplitude directions.

**16.** A Viterbi decoding circuit as claimed in claim 13, 14 or 15, wherein said first and second reverse converting means (323, 324) comprises a serial-input/parallel-output type shift register memory and a parallel-input/serial-output type shift register memory.

**17.** A Viterbi decoding circuit as claimed in 13, 14, 15 or 16, wherein said first and second forward converting means (326, 327) comprises a serial-input/parallel-output type shift register memory and a parallel-input/serial-output type shift register memory.

**18.** A Viterbi decoding circuit as claimed in any of claims 8 to 17, wherein said Viterbi decoding means (325) comprises:

an initial state setting circuit (325.1) for setting first and second initial states for each group;

a first decoding logic circuit (325.2) for performing a logic operation with respect to the first initial state and the reverse positive and negative peak data, respectively, to output a first reverse decoded data Viterbi-decoded with respect to the first initial state;

a second decoding logic circuit (325.3) for performing a logic operation with respect to the second initial state and the reverse positive and negative peak data, respectively, to output a second reverse decoded data Viterbi-decoded with respect to the second initial state; and

a selection control signal generating circuit (325.4) for generating a selection control signal based on the decoded value of the initial decoded data of the next group connected to the final decoded data of the group output from said first decoding logic circuit.

**19.** A Viterbi decoding circuit as claimed in any of claims 13 to 18, wherein said selecting means (328) comprises:

first and second shift registers for delaying the first and second forward decoded data until the selection control signal is generated; and

a switching device (SW) for selecting one of the outputs of said first and second shift registers responding to the selection control signal.

**Patentansprüche**

**1.** Viterbi-Decodierverfahren zum Decodieren eines Eingangssignals, welches die folgenden Schritte umfasst:

(a) Erfassen von Momentanwerten negativer und positiver Spitzendaten als Alternativen zu metrischen Angaben aus dem Eingangssignal;
(b) Gruppieren der erfassten Momentanwerte nach einer vorgegebenen Zeit und Ausgabe der gruppierten positiven und negativen Spitzendaten;
(c) Konvertieren der gruppierten positiven und negativen Spitzendaten in Rückwärtsrichtung und Ausgabe der umgekehrten positiven und negativen Daten;
(d) Viterbi-Decodieren der umgekehrten positiven und negativen Spitzendaten in Bezug auf die Anfangszustände einer vorgegebenen Anzahl und Ausgabe der rückwärts decodierten Daten einer vorgegebenen Anzahl von Kanälen;
(e) Konvertieren der rückwärts decodierten Daten jedes Kanals der vorgegebenen Anzahl von Kanälen in Vorwärtsrichtung und Ausgabe der vorwärts decodierten Daten von der vorgegebenen Anzahl von Kanälen; und
(f) Auswählen eines der vorwärts decodierten Datenelemente von der vorgegebenen Anzahl von Kanälen auf der Grundlage des Zustandes der decodierten Anfangsdaten der nächsten Gruppe, die im Zusammenhang mit den decodierten Enddaten der vorliegenden Gruppe stehen, und Ausgabe des ausgewählten Datenelements als decodiertes Enddatenelement.

**2.** Viterbi-Decodierverfahren gemäß Anspruch 1, wobei Schritt (f) den Schritt des Verzögerns vorwärts decodierter Daten von einer vorgegebenen Anzahl von Kanälen bis zu dem Zeitpunkt umfasst, an dem der Zustand der decodierten Anfangsdaten der nächsten Gruppe ermittelt ist.

**3.** Viterbi-Decodierverfahren gemäß Anspruch 1 oder 2, wobei die vorgegebene Anzahl von Kanälen zwei beträgt.

**4.** Viterbi-Decodierverfahren gemäß Anspruch 3, wobei Schritt (f) die folgenden Schritte umfasst:

(f1) Ermitteln eines Zustands von decodierten Anfangsdaten der nächsten Gruppe, die mit den decodierten Enddaten der vorliegenden Gruppe im Zusammenhang stehen; und
(f2) Auswählen eines der vorwärts decodierten Datenelemente von zwei Kanälen auf der Grundlage des ermittelten Zustandswertes, um die Gruppierung der decodierten Daten aufzuheben.

**5.** Viterbi-Decodierverfahren gemäß Anspruch 4, wobei Schritt (d) weiterhin den Schritt (c4) umfasst, in dem die vorwärts decodierten Daten von zwei Kanälen solange verzögert werden, bis der Zustandswert des ersten decodierten Datenelements der nächsten Gruppe ermittelt ist.

6. Viterbi-Decodierverfahren gemäß einem der vorangehenden Ansprüche, wobei die Anzahl von Bits in jeder Gruppe mit einem digitalen Modulationsverfahren ermittelt wird.

7. Viterbi-Decodierschaltung zum Decodieren eines Eingangssignals, welche umfasst:

   eine Erfassungseinrichtung (322) zum Erfassen von Momentanwerten positiver und negativer Spitzen als Alternativen zu metrischen Angaben aus dem Eingangssignal;
   eine erste Konvertierungseinrichtung (323, 324) zum Gruppieren der erfassten Momentandaten nach einer vorgegebenen Zeit und Konvertieren der gruppierten positiven und negativen Spitzendaten in Rückwärtsrichtung, um umgekehrte positive und negative Spitzendaten auszugeben;
   eine Viterbi-Decodiereinrichtung (325) zum Viterbi-Decodieren der umgekehrten positiven und negativen Spitzendaten in Bezug auf die Anfangszustände einer vorgegebenen Anzahl, um die rückwärts decodierten Daten einer vorgegebenen Anzahl von Kanälen auszugeben, und zum Ausgeben eines Auswahl-Steuersignals auf der Grundlage des Zustandes der decodierten Anfangsdaten der nächsten Gruppe, die im Zusammenhang mit den decodierten Enddaten der vorliegenden Gruppe stehen;
   eine zweite Konvertierungseinrichtung (326, 327) zum Konvertieren der rückwärts decodierten Daten von der vorgegebenen Anzahl von Kanälen in Vorwärtsrichtung und zum Ausgeben der vorwärts decodierten Daten von der vorgegebenen Anzahl von Kanälen; und
   eine Auswahleinrichtung (328) zum Auswählen eines der vorwärts decodierten Datenelemente aus der vorgegebenen Anzahl von Kanälen als Reaktion auf das Auswahl-Steuersignal und zum Ausgeben eines decodierten Enddatenelementes.

8. Viterbi-Decodierschaltung gemäß Anspruch 7, wobei die Anzahl von Kanälen zwei beträgt.

9. Viterbi-Decodierschaltung gemäß Anspruch 7 oder 8, wobei die erste Konvertierungseinrichtung (323, 324) einen Schieberegisterspeicher mit seriellem Eingang / parallelem Ausgang und einen Schieberegisterspeicher mit parallelem Eingang / seriellen Ausgang umfasst.

10. Viterbi-Decodierschaltung gemäß Anspruch 7, 8 oder 9, wobei die zweite Konvertierungseinrichtung (326, 327) einen Schieberegisterspeicher mit seriellem Eingang / parallelem Ausgang und einen Schieberegisterspeicher mit parallelem Eingang / seriellem Ausgang umfasst.

11. Viterbi-Decodierschaltung gemäß Anspruch, wobei die Auswahleinrichtung (328) umfasst:

    ein erstes und ein zweites Schieberegister zum Verzögern der vorwärts decodierten Daten von zwei Kanälen solange, bis das Auswahl-Steuersignal erzeugt ist; und
    eine Schaltvorrichtung (SW) zum Auswählen einer der Ausgangsgrößen von dem ersten und dem zweiten Schieberegister entsprechend dem Auswahl-Steuersignal.

12. Viterbi-Decodierschaltung gemäß Anspruch 7, 8, 9, 10 oder 11, wobei die Anzahl von Bits in jeder Gruppe mit einem digitalen Modulationsverfahren ermittelt wird.

13. Viterbi-Decodierschaltung zum Decodieren eines Signals gemäß Anspruch 7, wobei die Decodierschaltung einen Teil eines magnetischen Aufzeichnungs- / Wiedergabegerätes umfasst und weiterhin aufweist:

    eine Spitzenerfassungseinrichtung (322) zum Verketten der positiven und negativen Spitzenerfassungsschwellen, um die Differenz zwischen zwei Schwellen als vorgegebenen Offset-Wert beizubehalten, und zum Erfassen von Momentanwerten positiver und negativer Spitzen des wiedergegebenen Signals, um positive und negative Spitzendaten auszugeben;
    eine erste Rückwärts-Konvertierungseinrichtung (323) zum Gruppieren positiver Spitzendaten, die von der Spitzenerfassungseinrichtung (322) ausgegeben werden, nach einer vorgegebenen Zeit und zum Konvertieren der gruppierten positiven Spitzendaten in Rückwärtsrichtung, um ein umgekehrtes positives Spitzendatenelement auszugeben;
    eine zweite Rückwärts-Konvertierungseinrichtung (324) zum Gruppieren negativer Spitzendaten, die von der Spitzenerfassungseinrichtung (322) ausgegeben werden, nach einer vorgegebenen Zeit und zum Konvertieren der gruppierten negativen Spitzendaten in Rückwärtsrichtung, um ein umgekehrtes negatives Spitzendatenelement auszugeben;
    eine Viterbi-Decodiereinrichtung (325) zum Viterbi-Decodieren der umgekehrten positiven und negativen Spitzendaten, die von der ersten und der zweiten Rückwärts-Konvertierungseinrichtung (323, 324) ausgegeben werden, in Bezug auf den ersten und den zweiten Anfangszustandswert, um rückwärts decodierte Daten von zwei Kanälen auszugeben, und zum Ausgeben eines Auswahl-Steuersignals auf der Grundlage des Zustands der decodierten Anfangsdaten der nächsten Gruppe, die mit dem decodierten Enddatenelement der vorliegenden Gruppe im Zusammenhang stehen;

eine erste Vorwärts-Konvertierungseinrichtung (326) zum Konvertieren rückwärts decodierter Daten, die in Bezug auf den ersten Anfangszustand decodiert sind, in Vorwärtsrichtung, um ein erstes vorwärts decodiertes Datenelement auszugeben;

eine zweite Vorwärts-Konvertierungseinrichtung (327) zum Konvertieren eines zweiten rückwärts decodierten Datenelements, das in Bezug auf den zweiten Anfangszustandwert decodiert ist, in Vorwärtsrichtung, um ein zweites vorwärts decodiertes Datenelement auszugeben; und

eine Auswahleinrichtung (328) zum Auswählen von entweder dem ersten oder dem zweiten vorwärts decodierten Datenelement als Reaktion auf das Auswahl-Steuersignal, um das ausgewählte decodierte Datenelement auszugeben.

14. Viterbi-Decodierschaltung gemäß Anspruch 13, welche weiterhin einen Verstärker (321) zum Verstärken des wiedergegebenen Signals aufweist, um das verstärkte Signal an die Spitzenerfassungseinrichtung auszugeben.

15. Viterbi-Decodierschaltung gemäß Anspruch 13 oder 14, wobei die Spitzenerfassungseinrichtung (322) zwei Komparatoren (COMF1, COMP2) zum Vergleichen des wiedergegebenen Signals mit einem positiven bzw. negativen Spitzen-Schwellenwert umfasst, um codierte binäre Daten positiver (positive Spitzendaten) und negativer (negative Spitzendaten) Amplitudenrichtung auszugeben.

16. Viterbi-Decodierschaltung gemäß Anspruch 13, 14 oder 15, wobei die erste und die zweite Rückwärts-Konvertierungseinrichtung (323, 324) einen Schieberegisterspeicher mit seriellem Eingang/parallelem Ausgang und einen Schieberegisterspeicher mit parallelem Eingang/seriellem Ausgang umfassen.

17. Viterbi-Decodierschaltung gemäß Anspruch 13, 14, 15 oder 16, wobei die erste und die zweite Vorwärts-Konvertierungseinrichtung (326, 327) einen Schieberegisterspeicher mit seriellem Eingang/parallelem Ausgang und einen Schieberegisterspeicher mit parallelem Eingang/seriellem Ausgang umfassen.

18. Viterbi-Decodierschaltung gemäß einem der Ansprüche 8 bis 17, wobei die Viterbi-Decodiereinrichtung (325) umfasst:

eine Anfangszustands-Konfigurierungsschaltung (325.1) zum Konfigurieren eines ersten und zweiten Anfangszustandes für jede Gruppe;

eine erste logische Decodierschaltung (325.2) zum Ausführen einer logischen Operation in Bezug auf den ersten Anfangszustand und die umgekehrten positiven bzw. negativen Spitzendaten, um ein erstes rückwärts decodiertes Datenelement auszugeben, das in Bezug auf den ersten Anfangszustand Viterbi-decodiert ist;

eine zweite logische Decodierschaltung (325.3) zum Ausführen einer logischen Operation in Bezug auf den zweiten Anfangszustand und die umgekehrten positiven bzw. negativen Spitzendaten, um ein zweites rückwärts decodiertes Datenelement auszugeben, das in Bezug auf den zweiten Anfangszustand Viterbi-decodiert ist; und

eine Auswahl-Steuersignal-Erzeugungsschaltung (325.4) zum Erzeugen eines Auswahl-Steuersignals auf der Grundlage des decodierten Wertes der decodierten Anfangsdaten der nächsten Gruppe, die mit den decodierten Enddaten der Gruppe im Zusammenhang stehen, die aus der ersten logischen Decodierschaltung ausgegeben werden.

19. Viterbi-Decodierschaltung gemäß einem der Ansprüche 13 bis 18, wobei die Auswahleinrichtung (328) umfasst:

ein erstes und ein zweites Schieberegister zum Verzögern des ersten und zweiten vorwärts decodierten Datenelements solange, bis das Auswahl-Steuersignal erzeugt ist; und

eine Schaltvorrichtung (SW) zum Auswählen einer der Ausgangsgrößen des ersten und zweiten Schieberegisters als Reaktion auf das Auswahl-Steuersignal.

## Revendications

1. Procédé de décodage de Viterbi pour décoder un signal d'entrée comportant les étapes consistant à :

(a) détecter des valeurs instantanées de données de crêtes négatives et positives comme des alternatives de métriques à partir du signal d'entrée,
(b) grouper les valeurs instantanées détectées selon une durée prédéterminée et délivrer en sortie les données de crêtes positives et négatives groupées,

(c) convertir les données de crêtes positives et négatives groupées dans la direction inverse et délivrer en sortie les données positives et négatives inverses,

(d) décoder selon le procédé de Viterbi les données de crêtes positives et négatives inverses par rapport aux états initiaux d'un nombre prédéterminé et délivrer en sortie les données décodées inverses d'un nombre prédéterminé de canaux,

(e) convertir les données décodées inverses de chaque canal du nombre prédéterminé de canaux dans la direction avant et délivrer en sortie les données décodées avant des canaux d'un nombre prédéterminé, et

(f) sélectionner l'une parmi les données décodées avant du nombre prédéterminé de canaux en se basant sur l'état des données décodées initiales du groupe suivant liées à des données décodées finales du présent groupe et délivrer en sortie les données sélectionnées en tant que données décodées finales.

**2.** Procédé de décodage de Viterbi selon la revendication 1, dans lequel ladite étape (f) comporte l'étape consistant à retarder les données décodées avant d'un nombre prédéterminé de canaux jusqu'à ce que l'état des données décodées initiales du groupe suivant soit déterminé.

**3.** Procédé de décodage de Viterbi selon la revendication 1 ou 2, dans lequel ledit nombre prédéterminé de canaux est de deux.

**4.** Procédé de décodage de Viterbi selon la revendication 3, dans lequel ladite étape (f) comporte les étapes consistant à :

(f1) déterminer un état de données décodées initiales du groupe suivant liées aux données décodées finales du présent groupe, et

(f2) sélectionner l'une parmi les données décodées avant de deux canaux en se basant sur la valeur de l'état déterminé pour dégrouper les données décodées.

**5.** Procédé de décodage de Viterbi selon la revendication 4, dans lequel ladite étape (d) comporte de plus l'étape (c4) consistant à retarder les données décodées avant de deux canaux jusqu'à ce que la valeur d'état de premières données décodées du groupe suivant soit déterminée.

**6.** Procédé de décodage de Viterbi selon l'une quelconque des revendications précédentes, dans lequel le nombre de bits dans chaque groupe est déterminé par un procédé de modulation numérique.

**7.** Circuit de décodage de Viterbi pour décoder un signal d'entrée comportant :

des moyens de détection (322) pour détecter des valeurs instantanées de crêtes positives et négatives comme des alternatives de métriques à partir du signal d'entrée,

des premiers moyens de conversion (323, 324) pour grouper les données instantanées détectées selon une durée prédéterminée et convertir les données de crêtes positives et négatives groupées dans la direction inverse pour délivrer en sortie des données de crêtes positives et négatives inverses,

des moyens de décodage de Viterbi (325) pour décoder selon le procédé de Viterbi les données de crêtes positives et négatives inverses par rapport aux états initiaux d'un nombre prédéterminé pour délivrer en sortie des données décodées inverses d'un nombre prédéterminé de canaux, et pour délivrer en sortie un signal de commande de sélection en se basant sur l'état des données décodées initiales du groupe suivant liées à des données décodées finales du présent groupe,

des seconds moyens de conversion (326, 327) pour convertir les données décodées inverses du nombre prédéterminé de canaux dans la direction avant et délivrer en sortie les données décodées avant du nombre prédéterminé de canaux, et

des moyens de sélection (328) pour sélectionner l'une parmi les données décodées avant du nombre prédéterminé de canaux sensible au signal de commande de sélection et délivrer en sortie des données décodées finales.

**8.** Circuit de décodage de Viterbi selon la revendication 7, dans lequel le nombre de canaux est de deux.

**9.** Circuit de décodage de Viterbi selon la revendication 7 ou 8, dans lequel lesdits premiers moyens de conversion (323, 324) comportent une mémoire de registre à décalage de type entrée série/sortie parallèle et une mémoire de registre à décalage de type entrée parallèle/sortie série.

**10.** Circuit de décodage de Viterbi selon la revendication 7, 8 ou 9, dans lequel lesdits seconds moyens de conversion (326, 327) comportent une mémoire de registre à décalage de type entrée série/sortie parallèle et une mémoire de registre à décalage de type entrée parallèle/sortie série.

**11.** Circuit de décodage de Viterbi selon la revendication, dans lequel lesdits moyens de sélection (328) comportent :

un premier et un second registre à décalage pour retarder les données décodées avant de deux canaux jusqu'à ce que le signal de commande de sélection soit généré, et

un dispositif de commutation (SW) pour sélectionner l'une parmi les sorties desdits premier et second registres à décalage conformément au signal de commande de sélection.

**12.** Circuit de décodage de Viterbi selon l'une quelconque des revendications 7, 8, 9, 10 ou 11, dans lequel le nombre de bits dans chaque groupe est déterminé par un procédé de modulation numérique.

**13.** Circuit de décodage de Viterbi pour décoder un signal selon la revendication 7, ledit circuit de décodage comportant une partie d'un dispositif d'enregistrement/lecture magnétique et comportant de plus :

des moyens de détection de crêtes (322) pour verrouiller des seuils de détection de crêtes positives et négatives afin de conserver la différence entre deux seuils en tant que valeur de décalage prédéterminée et détecter des valeurs instantanées de crêtes positives et négatives du signal lu pour délivrer en sortie des données de crêtes positives et négatives,

des premiers moyens de conversion inverse (323) pour grouper des données de crêtes positives délivrées en sortie par lesdits moyens de détection de crêtes (322) selon une durée prédéterminée et convertir les données de crêtes positives groupées dans la direction inverse pour délivrer en sortie des données de crêtes positives inverses,

des seconds moyens de conversion inverse (324) pour grouper des données de crêtes négatives délivrées en sortie par lesdits moyens de détection de crêtes (322) selon une durée prédéterminée et convertir les données de crêtes négatives groupées dans la direction inverse pour délivrer en sortie des données de crêtes négatives inverses,

des moyens de décodage de Viterbi (325) pour décoder selon le procédé de Viterbi les données de crêtes positives et négatives inverses délivrées en sortie par lesdits premiers et seconds moyens de conversion inverse (323, 324) par rapport aux première et seconde valeurs d'état initial pour délivrer en sortie des données décodées inverses de deux canaux, et pour délivrer en sortie un signal de commande de sélection en se basant sur l'état des données décodées initiales du groupe suivant liées aux données décodées finales du présent groupe,

des premiers moyens de conversion avant (326) pour convertir des données décodées inverses qui sont décodées par rapport au premier état initial dans la direction avant pour délivrer en sortie des premières données décodées avant,

des seconds moyens de conversion avant (327) pour convertir des secondes données décodées inverses qui sont décodées par rapport à la seconde valeur d'état initial dans la direction avant pour délivrer en sortie des secondes données décodées avant, et

des moyens de sélection (328) pour sélectionner l'une parmi des premières et secondes données décodées avant sensible au signal de commande de sélection pour délivrer en sortie les données décodées sélectionnées.

**14.** Circuit de décodage de Viterbi selon la revendication 13, comportant de plus un amplificateur (321) pour amplifier le signal lu afin de délivrer en sortie le signal amplifié auxdits moyens de détection de crêtes.

**15.** Circuit de décodage de Viterbi selon la revendication 13 ou 14, dans lequel lesdits moyens de détection de crêtes (322) comportent deux comparateurs (COMP1, COMP2) pour comparer le signal lu à des seuils de crêtes positives et négatives, respectivement, pour délivrer en sortie des données binaires codées dans les directions d'amplitude positive (données de crêtes positives) et négative (données de crêtes négatives).

**16.** Circuit de décodage de Viterbi selon la revendication 13, 14 ou 15, dans lequel lesdits premiers et seconds moyens de conversion inverse (323, 324) comportent une mémoire de registre à décalage de type entrée série/sortie parallèle et une mémoire de registre à décalage de type entrée parallèle/sortie série.

**17.** Circuit de décodage de Viterbi selon la revendication 13, 14, 15 ou 16, dans lequel les premiers et seconds moyens de conversion avant (326, 327) comportent une mémoire de registre à décalage de type entrée série/sortie parallèle et une mémoire de registre à décalage de type entrée parallèle/sortie série.

**18.** Circuit de décodage de Viterbi selon l'une quelconque des revendications 8 à 17, dans lequel lesdits moyens de décodage de Viterbi (325) comportent :

un circuit d'établissement d'état initial (325.1) pour établir des premier et second états initiaux pour chaque groupe,

un premier circuit logique de décodage (325.2) pour exécuter une opération logique se rapportant au premier état initial et aux données de crêtes positives et négatives inverses, respectivement, pour délivrer en sortie des premières données décodées inverses décodées selon le procédé de Viterbi se rapportant au premier état initial,

un second circuit logique de décodage (325.3) pour exécuter une opération logique se rapportant au second état initial et aux données de crêtes positives et négatives inverses, respectivement, pour délivrer en sortie des secondes données décodées inverses décodées selon le procédé de Viterbi se rapportant au second état initial, et

un circuit de génération de signal de commande de sélection (325.4) pour générer un signal de commande de sélection en se basant sur la valeur décodée des données décodées initiales du groupe suivant liées aux données décodées finales du groupe délivrées en sortie par ledit premier circuit logique de décodage.

19. Circuit de décodage de Viterbi selon l'une quelconque des revendications 13 à 18, dans lequel lesdits moyens de sélection (328) comportent :

des premier et second registres à décalage pour retarder les premières et secondes données décodées avant jusqu'à ce que le signal de commande de sélection soit généré, et
un dispositif de commutation (SW) pour sélectionner l'une parmi les sorties desdits premier et second registres à décalage sensible au signal de commande de sélection.

# FIG. 1

EP 0 802 634 B1

# FIG. 2

FROM
ERROR-CORRECTION
ENCODER(140)

┌─ 150 ──────────────────────────────────────────────┐

151 152 153

CHANNEL
MODULATOR → PRECODER → RECORDING
COMPENSATION
CIRCUIT

TO
RECORDING
AMPLIFIER(160)

# FIG. 3

TO
ERROR-CORRECTION
DECODER(230)

227 226 224 223 222 221 220

CHANNEL
DECODER ← VITERBI
DECODING
CIRCUIT ← EQUALIZER ← A/D
CONVERTER ← LOW PASS
FILTER ← AGC

225

TIMING
DETECTOR

FROM
PLAYBAKC
AMPLIFIER(210)

EP 0 802 634 B1

EP 0 802 634 B1

# FIG. 4A

$$b_k = -a_k \cdot b_{k-1}$$

152 ⊣

12

INPUT
$a_k \in \{1, -1\}$

⊕

11

D

$b_k$

200

MAGNETIC RECORDING /REPRODUCING CHANNEL(I-D)

$z_k$

201

⊕

$n_k$

$y_k = z_k + n_k$

226

VITERBI DECODING CIRCUIT

$c_k$

# FIG. 4B

"−1"/0

$S = -1$

$b_k = 1$

"1"/+2

"1"/−2

"−1"/0

$S = +1$

$b_k = -1$

"$a_k$"/$z_k$

FIG. 5A

| REFERENCE TIME | k | 0 | 1 | 2 | 3 | 4 | 5 | 6 | 7 |
|---|---|---|---|---|---|---|---|---|---|
| INPUT DATA | $a_k$ | −1 | 1 | 1 | −1 | 1 | −1 | −1 | 1 |
| PRECODER OUTPUT | $b_k$ | −1 | 1 | −1 | −1 | 1 | 1 | 1 | −1 |
| IMPULSE RESPONCE OF EACH CHANNEL | $b_0(1-D)$ | −1 | 1 | | | | | | |
| | $b_1(1-D)$ | | 1 | −1 | | | | | |
| | $b_2(1-D)$ | | | −1 | 1 | | | | |
| | $b_3(1-D)$ | | | | −1 | 1 | | | |
| | $b_4(1-D)$ | | | | | 1 | −1 | | |
| | $b_5(1-D)$ | | | | | | 1 | −1 | |
| | $b_6(1-D)$ | | | | | | | 1 | −1 |
| | $b_7(1-D)$ | | | | | | | | −1 |
| CHANNEL OUTPUT $y_k$ | | | 2 | −2 | 0 | 2 | 0 | 0 | −2 |
| DECODED DATA $C_k$ | | | 1 | 1 | −1 | 1 | −1 | −1 | 1 |

FIG. 5B

FIG. 5C

# FIG. 6A

| TIME K | 0 | 1 | 2 | 3 | 4 | 5 | 6 | 7 | 8 |
|---|---|---|---|---|---|---|---|---|---|

DETECTION DATA($y_k$)  −1  0  0  0  0  1  −1  0  1

DECODED DATA($c_k$)  1  −1  −1  −1  −1  1  1  −1  1

# FIG. 6B

S=1

S=−1

# FIG. 7A

TIME K    0    1    2    3    4    5    6    7    8

DETECTION DATA    −1    0    0    1    0    1    −1    0    1

# FIG. 7B

S=1

S=−1

CORRECTED
DETECTION DATA (y'k)    −1    0    0    0    0    1    −1    0    1

DECODED DATA (Ck)    1    −1    −1    −1    −1    1    1    −1    1

# FIG. 8 (PRIOR ART)

EP 0 802 634 B1

# FIG. 9

```
                340              320                    310
      TO     ┌─────────┐   ┌──────────┐          ┌──────────┐     FROM
ERROR-CORRECTION│ CHANNEL │  │ VITERBI  │          │          │   PLAYBAKC
  DECODER    ◄──│ DEMOD-  │◄─│ DECODING │◄───┬─────│EQUALIZER │◄─ AMPLIFIER
             │ ULATOR  │  │ CIRCUIT  │    │    │          │
             └─────────┘   └──────────┘    │    └──────────┘
                             ▲             │         ▲
                             │        ┌──────────┐   │
                             └────────│  TIMING  │───┘
                                      │ DETECTOR │
                                      └──────────┘
                                          330
```

# FIG. 10

```
                        323                325            326             328
                    ┌──────────┐      ┌──────────┐   ┌──────────┐    ┌──────────┐
                    │1ST REVERSE│ Hn' │ INITIAL  │Ck1'│1ST FORWARD│Ck1 │          │
                ┌──►│ DIRECTION │────►│  STATE   │──►│ DIRECTION │───►│          │
                │   │ CONVERTER │      │ SETTING  │   │ CONVERTER │    │          │
 INPUT   ┌────────┐ │ └──────────┘      │    &     │   └──────────┘    │          │
 SIGNAL  │AMPLIFIER│ │PEAK    │ Hn      │ VITERBI  │                  │ SELECTOR │──► Ck
 ───────►│         │─│DETECTOR│─┤       │ DECODING │    327           │          │
         └────────┘ └────────┘ │       │ CIRCUIT  │   ┌──────────┐    │          │
              321      322     │ Ln    │          │Ck0'│2ND FORWARD│Ck0 │          │
                    ┌──────────┐│       │          │──►│ DIRECTION │───►│          │
                └──►│2ND REVERSE│ Ln'   │          │   │ CONVERTER │    │          │
                    │ DIRECTION │────►──┘          │   └──────────┘    └──────────┘
                    │ CONVERTER │      └──────────┘                        ▲
                    └──────────┘                          SEL             │
                        324    └──────────────────────────────────────────┘
```

# FIG. 11

# FIG. 12